# EUROPEAN PATENT APPLICATION

(11) **EP 4 395 080 A1**
(43) Date of publication of application: **03.07.2024**
(21) Application number: 22871912.6
(22) Date of filing: 19.09.2022
(51) Int. Cl.: H01R 12/72, H01R 12/73

(54) **ORTHOGONAL SYSTEM ARCHITECTURE AND NETWORK DEVICE**

(30) Priority: 24.09.2021 CN 202111120152
(71) Applicant: Huawei Technologies Co., Ltd., Shenzhen, Guangdong 518129 (CN)
(72) Inventor: YE, Jinhua, Shenzhen, Guangdong 518129 (CN); WANG, Lianqiang, Shenzhen, Guangdong 518129 (CN); YE, Jilong, Shenzhen, Guangdong 518129 (CN)
(74) Representative: Körber, Martin Hans
(86) International application number: PCT/CN2022/119625
(87) International publication number: WO 2023/045866

(57) **Abstract**

This application provides an orthogonal system architecture and a network device. The orthogonal system architecture includes a first circuit board, a second circuit board, a first connector, and a second connector. The first circuit board and the second circuit board are disposed vertically to each other. The first connector is electrically connected to the first circuit board via a first cable assembly, the second connector is disposed on the second circuit board and is electrically connected to the second circuit board, and the first connector is plug-connected to the second connector, to electrically connect the first circuit board to the second circuit board. When the foregoing structure is used, the first circuit board is electrically connected to the first connector via the first cable assembly. Compared with transmitting a signal through a transmission line on a board, a cable has good high-speed performance and a low signal loss. This improves system high-speed performance. In addition, a signal is transmitted through the cable, so that cross transmission lines in the first circuit board can be avoided. In this way, restrictions on a quantity of layers and a board material of the first circuit board are relaxed, and design and manufacturing difficulties of the circuit board are reduced.

## Description

### CROSS-REFERENCE TO RELATED APPLICATIONS

This application claims priority to Chinese Patent Application No. 202111120152.1, filed with the China National Intellectual Property Administration on September 24, 2021 and entitled "ORTHOGONAL SYSTEM ARCHITECTURE AND NETWORK DEVICE", which is incorporated herein by reference in its entirety.

### TECHNICAL FIELD

This application relates to the field of network device technologies, and in particular, to an orthogonal system architecture and a network device.

### BACKGROUND

With continuous development of 5G, cloudification, and an intelligent network service, bandwidth of a network interface increases, and a requirement for a switching capability of a network device increases. In a network device system architecture, all data needs to be exchanged via a backplane. This poses higher requirements on backplane bandwidth and a bus rate. In addition, with continuous development of chip technologies, a rate of a chip bus continues to increase, and gradually evolves from 56 Gbit/s to 112 Gbit/s. The backplane needs to support a higher rate and have a lower insertion loss and lower crosstalk. Capability improvement of the backplane becomes a very important factor for improving system bandwidth.

An orthogonal system architecture is a system architecture commonly used for a network device. As the name implies, the orthogonal system architecture is a vertical architecture, and boards that implement signal exchange are inserted vertically to each other, and are disposed one by one. The orthogonal system architecture includes a backplane orthogonal system architecture and a backplane-free orthogonal system architecture. For the backplane orthogonal system architecture, a signal line needs to be routed via a backplane. A loss thereof is similar to a loss of a conventional printed circuit board (printed circuit board, PCB) backplane system architecture. An evolution capability is weak. For the backplane-free orthogonal system architecture, board connectors are directly inserted to each other to implement signal exchange between boards. An insertion loss on an original backplane is directly reduced to zero, and a system loss is greatly reduced. This helps increase a system signal rate. A system evolution capability is strong.

However, although the backplane is omitted in the backplane-free orthogonal system architecture, cross transmission lines on the original backplane may be split and introduced to two boards inserted to each other, and the transmission line on the board is increased. The board usually needs to use a clock data recovery (clock data recovery, CDR) chip to resolve a problem of a high loss caused by the long transmission line. This increases power consumption, and brings a frontto-back cascading heat dissipation challenge. In addition, with evolution of larger bandwidth, a problem of high system power consumption is increasingly serious.

### SUMMARY

This application provides an orthogonal system architecture and a network device, to reduce system power consumption of the network device.

According to a first aspect, this application provides an orthogonal system architecture, including a first circuit board, a second circuit board, a first connector, and a second connector. The first circuit board and the second circuit board are disposed vertically to each other to form an orthogonal architecture. The first connector is electrically connected to the first circuit board via a first cable assembly, to reduce a signal loss. The second connector is disposed on the second circuit board and is electrically connected to the second circuit board. The first connector is plug-connected to the second connector, to electrically connect the first circuit board to the second circuit board.

According to the technical solution provided in this application, a backplane-free orthogonal system architecture is used to implement vertical inter-insertion between the first circuit board and the second circuit board. Compared with a backplane orthogonal system architecture, a group of inter-board connectors are reduced. Therefore, a system insertion loss is reduced, a signal loss of a transmission line on a backplane is avoided, and system high-speed performance is improved. The first circuit board is electrically connected to the first connector via the first cable assembly. Compared with transmitting a signal through a transmission line on a board, a cable has relatively good high-speed performance and a relatively low signal loss. This further improves the system high-speed performance and reduces system power consumption. In addition, a signal is transmitted through the cable, so that cross transmission lines in the first circuit board can be avoided. In this way, restrictions on a quantity of layers and a board material of the first circuit board are relaxed, and design and manufacturing difficulties of the circuit board are reduced.

In a specific implementable solution, the first connector is a straight male connector, and the second connector is a curved female connector. Alternatively, the first connector is a curved female connector, and the second connector is a straight male connector. The straight male connector and the curved female connector form a group of inter-board connectors. Vertical inter-insertion between the first circuit board and the second circuit board is implemented through plug-connection and fitting between the straight male connector and the curved female connector. Compared with implementing vertical inter-insertion between boards through plug-connection and fitting between a curved male connector and the curved female connector, an insertion loss caused by a design in which a pin of one connector in one group of connectors is rotated by 90° is reduced.

In a specific implementable solution, the first cable assembly includes a first cable and a first board-end connector. The first board-end connector is disposed on the first circuit board and is electrically connected to the first circuit board, one end of the first cable is electrically connected to the first board-end connector, and the other end of the first cable is electrically connected to the first connector. The first connector is electrically connected to the first circuit board, so that a transmission line on the first circuit board can be shortened, and the system power consumption is reduced.

In a specific implementable solution, the second connector is electrically connected to the second circuit board via a second cable assembly. The second circuit board is electrically connected to the second connector via the second cable assembly. Compared with transmitting a signal through a transmission line on the second circuit board, a cable has relatively good high-speed performance and a relatively low signal loss. This further improves system high-speed performance and reduces system power consumption. In addition, a signal is transmitted through the cable, so that cross transmission lines in the second circuit board can be avoided. In this way, restrictions on a quantity of layers and a board material of the second circuit board are relaxed, and design and manufacturing difficulties of the circuit board are reduced.

In a specific implementable solution, the first connector is a straight male connector, and the second connector is a curved female connector or a straight female connector. Alternatively, the first connector is a curved female connector or a straight female connector, and the second connector is a straight male connector. The straight male connector and the curved female connector form a group of inter-board connectors. Vertical inter-insertion between the first circuit board and the second circuit board is implemented through plug-connection and fitting between the straight male connector and the curved female connector. Compared with implementing vertical inter-insertion between boards through plug-connection and fitting between a curved male connector and the curved female connector, an insertion loss caused by a design in which a pin of one connector in one group of connectors is rotated by 90° is reduced. The straight male connector and the straight female connector form a group of inter-board connectors. Vertical inter-insertion between the first circuit board and the second circuit board is implemented through plug-connection and fitting between the straight male connector and the straight female connector. Compared with implementing vertical inter-insertion between boards through plug-connection and fitting between a curved male connector and the curved female connector, an insertion loss caused by a design in which pins of two connectors in one group of connectors are rotated by 90° is reduced.

In a specific implementable solution, the second cable assembly includes a second cable and a second board-end connector. The second board-end connector is disposed on the second circuit board and is electrically connected to the second circuit board, one end of the second cable is electrically connected to the second board-end connector, and the other end of the second cable is electrically connected to the second connector. The second connector is electrically connected to the second circuit board, so that the transmission line on the second circuit board can be shortened, and the system power consumption is reduced. Overall power consumption of the system is greatly reduced.

In a specific implementable solution, the orthogonal system architecture further includes an installation board. The installation board is disposed between the first circuit board and the second circuit board, and the first connector is disposed on the installation board, to implement positioning of the first connector.

In a specific implementable solution, a window is disposed on the installation board, and the first connector is disposed in the window. Positioning of the first connector is convenient.

In a specific implementable solution, the orthogonal system architecture further includes a housing, and the first circuit board is disposed in the housing. The installation board is disposed outside the housing and faces a side wall of the housing. Protection and electromagnetic shielding are performed on the first circuit board via the housing.

In a specific implementable solution, the orthogonal system architecture further includes a housing, and the first circuit board is disposed in the housing. The housing has an opening, and the installation board is disposed on the opening. Protection and electromagnetic shielding are performed on the first circuit board via the housing. The installation board and the housing are easy to assemble.

According to a second aspect, this application provides a network device, including an interface processing unit and the foregoing orthogonal system architecture. The interface processing unit is disposed on a first circuit board or a second circuit board.

According to the technical solution provided in this application, a packet entered from the interface processing unit can be switched to another port via the orthogonal system architecture, to implement a plurality of functions of the network device. The orthogonal system architecture uses a backplane-free orthogonal system architecture. A signal loss is low, and high-speed performance is good. In addition, a cable is used to implement an electrical connection between a connector and a circuit board. This greatly improves system high-speed performance and greatly reduces system power consumption.

According to a third aspect, this application provides a method for manufacturing an orthogonal system architecture, including: electrically connecting one end of a first cable assembly to a first circuit board; disposing an installation board, to enable the first circuit board to be located on one side of the installation board, disposing a first connector on the installation board, and electrically connecting the first connector to the other end of the first cable assembly, to electrically connect the first connector to the first circuit board; disposing a second circuit board, to enable the second circuit board to be located on another side of the installation board, disposing a second connector on the second circuit board, and electrically connecting the second connector to the second circuit board; and disposing the second circuit board vertically to the first circuit board, and plug-connecting the second connector to the first connector to electrically connect the second circuit board to the first circuit board in a vertical inter-insertion manner, to form a backplane-free orthogonal system architecture.

According to the technical solution provided in this application, the first circuit board is electrically connected to the first connector via the first cable assembly. Compared with transmitting a signal through a transmission line on a board, a cable has relatively good high-speed performance and a relatively low signal loss. This improves system high-speed performance and reduces system power consumption. In addition, a signal is transmitted through the cable, cross transmission lines in the first circuit board can be avoided. In this way, restrictions on a quantity of layers and a board material of the first circuit board are relaxed, and design and manufacturing difficulties of the circuit board are reduced. The second connector is plug-connected to the first connector, so that vertical inter-insertion between the first circuit board and the second circuit board is implemented, to form the backplane-free orthogonal system architecture. Compared with a backplane orthogonal system architecture, a group of inter-board connectors are reduced. Therefore, a system insertion loss is reduced, a signal loss of a transmission line on a backplane is avoided, and the system high-speed performance is improved.

In a specific implementable solution, the second connector is electrically connected to the second circuit board via a second cable assembly. Disposing of the second cable assembly implements the electrical connection between the second connector and the second circuit board. This can shorten a transmission line on the second circuit board and reduce the system power consumption. Overall power consumption of the system is greatly reduced.

### BRIEF DESCRIPTION OF DRAWINGS

FIG. 1 is a schematic diagram of a structure of an orthogonal system architecture according to an embodiment of this application;
FIG. 2 is a schematic diagram of a partial structure of FIG. 1;
FIG. 3 is a schematic top view of a structure of an orthogonal system architecture according to an embodiment of this application;
FIG. 4 is a schematic side view of a structure of an orthogonal system architecture according to an embodiment of this application;
FIG. 5 is a partial schematic diagram of a structure of an orthogonal system architecture according to an embodiment of this application; and
FIG. 6 is a schematic side view of a structure of another orthogonal system architecture according to an embodiment of this application.

### Reference numerals:

100: first circuit board; 200: second circuit board; 300: first connector; 400: second connector;
500: first cable assembly; 600: second cable assembly; 700: installation board; 800: housing; 101: first chip;
201: second chip; 501: first cable; 502: first board-end connector; 601: second cable; and
602: second board-end connector.

### DESCRIPTION OF EMBODIMENTS

The following describes in detail embodiments of this application with reference to the accompanying drawings.

For ease of understanding, an application scenario of an orthogonal system architecture related to this application is first described. The orthogonal system architecture provided in embodiments of this application is adapted to a network device, such as a router a data center (data center, DC) switch, or the like, and is used as a board-level interconnection architecture to implement inter-board signal transmission.

The network device usually includes a control unit, an interface processing unit, a switching/forwarding unit, and the like. These units are connected by using a service bus for communication, to ensure that a packet entered from the interface processing unit can be switched to another port internally. A specific implementation may be that the interface processing unit is disposed on a backplane, and then the interconnection between the units is implemented via the backplane. In other words, the backplane is used as a resource pool.

A network device using the orthogonal system architecture is used as an example, and the orthogonal system architecture includes a backplane architecture and a backplane-free architecture. For the backplane-free architecture, vertical inter-insertion between boards is implemented via an orthogonal connector. Although a backplane is omitted, cross transmission lines originally existing on the backplane may be split and introduced to two boards inserted to each other, and the transmission line on the board and a signal loss are increased. A clock data recovery chip (clock data recovery, CDR) usually needs to be disposed on the board to resolve a problem of a high signal loss caused by long cabling. This increases system power consumption.

Based on this, embodiments of this application provide an orthogonal system architecture, to reduce the signal loss and improve system high-speed performance.

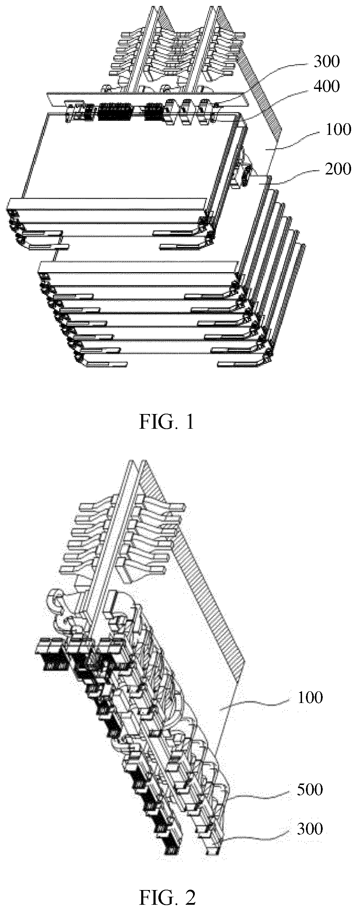

First, FIG. 1 is a schematic diagram of a structure of an orthogonal system architecture according to an embodiment of this application. As shown in FIG. 1, in some embodiments, the orthogonal system architecture provided in this application includes a first circuit board 100, a second circuit board 200, a first connector 300, and a second connector 400. The first circuit board 100 and the second circuit board 200 are disposed vertically to each other, and may be used as a pair of boards vertically inserted to each other in the foregoing backplane-free orthogonal system architecture. The first connector 300 and the second connector 400 form a group of connectors. The first connector 300 is connected to the second connector 400 in a pluggable manner. FIG. 1 shows a state of plug-connection between the first connector 300 and the second connector 400. In this state, the first connector 300 and the second connector 400 may be vertically inserted to each other, so that the first connector 300 is electrically connected to the second connector 400.

Refer to FIG. 1 and FIG. 2 together. FIG. 2 is a schematic diagram of a partial structure of FIG. 1. The second circuit board and the second connector are hidden in FIG. 2. As shown in FIG. 2, during specific disposing, the first connector 300 may be electrically connected to the first circuit board 100 via a first cable assembly 500.

During specific disposing, the second connector 400 may be directly installed on the second circuit board 200, to implement an electrical connection to the second circuit board 200. The second connector 400 may be specifically installed on the second circuit board 200 in a crimping manner, or may be directly installed by using a screw in a spring manner, so that a pin of the second connector 400 is directly connected to a pin of the second circuit board 200, to further implement the electrical connection between the second connector 400 and the second circuit board 200.

The orthogonal system architecture in this embodiment of this application uses a backplane-free orthogonal system architecture to implement vertical inter-insertion between the first circuit board 100 and the second circuit board 200. Compared with a backplane orthogonal system architecture, a group of connectors are reduced. Therefore, a system insertion loss can be reduced, a signal loss of a transmission line on the backplane can be avoided, and system high-speed performance can be improved. The first circuit board 100 is electrically connected to the first connector 300 via the first cable assembly 500. Compared with transmitting a signal through a transmission line on a board, a cable has relatively good high-speed performance and a relatively low signal loss. Therefore, the system high-speed performance can be further improved. In addition, a signal is transmitted through the cable, cross transmission lines in the first circuit board 100 can be avoided. In this way, restrictions on a quantity of layers and a board material of the first circuit board 100 are relaxed. This helps reduce design and manufacturing costs of the circuit board.

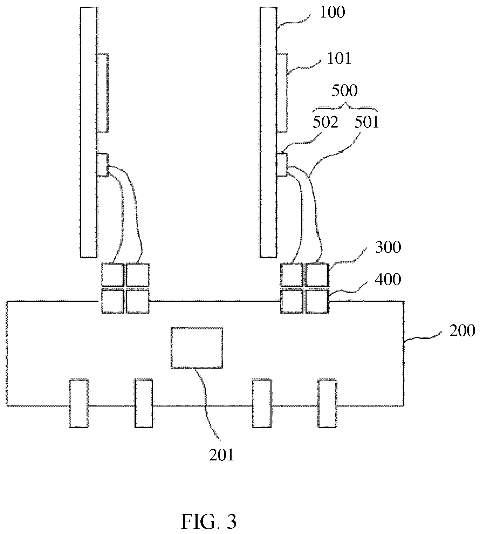

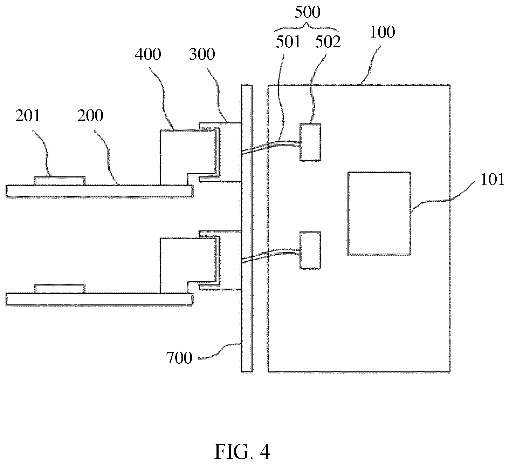

Refer to FIG. 3 and FIG. 4. FIG. 3 is a schematic top view of a structure of an orthogonal system architecture according to an embodiment of this application. FIG. 4 is a schematic side view of a structure of an orthogonal system architecture according to an embodiment of this application. As shown in FIG. 3 and FIG. 4, a first chip 101 may be disposed on the first circuit board 100, and an end that is of the first cable assembly 500 and that is electrically connected to the first circuit board 100 may be electrically connected to the first chip 101 through an intra-board transmission line. During specific implementation, the end that is of the first cable assembly 500 and that is electrically connected to the first circuit board 100 may be disposed close to the first chip 101, so that the intra-board transmission line can be greatly shortened, and signal integrity (signal integrity, SI) of the circuit board can be improved. In addition, this disposing manner can further reduce CDR on the circuit board, to reduce the system power consumption. A second chip 201 may be disposed on the second circuit board 200, and the second connector 400 may be electrically connected to the second chip 201 through a transmission line in the second circuit board 200.

There may be at least one first circuit board 100 and at least one second circuit board 200. The orthogonal system architecture in this embodiment of this application is applicable to a one-to-one circuit board interconnection, a one-to-many circuit board interconnection, and a many-to-many circuit board interconnection. One-to-one may be understood as that one first circuit board 100 is interconnected to one second circuit board 200. One-to-many may be understood as that one first circuit board 100 is interconnected to a plurality of second circuit boards 200, or one second circuit board 200 is interconnected to a plurality of first circuit boards 100. Many-to-many may be understood as that a plurality of first circuit boards 100 are interconnected to a plurality of second circuit boards 200. For an electrical connection between one first circuit board 100 and one second circuit board 200, one group of connectors may be used, or a plurality of groups of connectors may be used. To be specific, the electrical connection between the one first circuit board 100 and the one second circuit board 200 may be implemented through plug-connection and fitting between one first connector 300 and one second connector 400. Alternatively, the electrical connection between the one first circuit board 100 and the one second circuit board 200 may be implemented through one-to-one plug-connection and fitting between a plurality of first connectors 300 and a plurality of second connectors 400.

In a possible embodiment, the first connector 300 and the second connector 400 that are mutually plug-connected and fitted may use a straight male connector and a curved female connector that are mutually plug-connected and fitted. For example, the first connector 300 uses the straight male connector, and the second connector 400 uses the curved female connector. Alternatively, the first connector 300 uses the curved female connector, and the second connector 400 uses the straight male connector. FIG. 4 shows a case in which the first connector 300 uses the straight male connector, and the second connector 400 uses the curved female connector.

In an existing orthogonal system architecture, vertical inter-insertion between boards is implemented via at least one group of orthogonal connectors, to be specific, at least one group of plug-connected and fitted curved male connectors and curved female connectors. A pin of a curved male connector and a pin of a curved female connector are both designed to be rotated by 90°, leading to a high connector insertion loss. In this embodiment of this application, because the first cable assembly 500 is introduced, the connector as a whole can be rotated by any angle by using a flexible feature of the cable. For example, the straight male connector may be rotated by 90°, to fit with the curved female connector in the orthogonal system architecture. In other words, the vertical inter-insertion between boards can be implemented through plug-connection and fitting between the straight male connector and the curved female connector. Compared with the existing orthogonal system architecture that implements, by using an orthogonal connector, the vertical inter-insertion between boards, the orthogonal system architecture in this embodiment of this application can implement the vertical inter-insertion between boards through plug-connection and fitting between the straight male connector and the curved female connector. An insertion loss caused by a design in which a pin of one connector in one group of connectors is rotated by 90° is reduced. Especially, when a plurality of groups of connectors are used for interconnection between boards, the insertion loss is reduced significantly.

In another possible embodiment, the first connector 300 and the second connector 400 that are plug-connected and fitted may alternatively separately use optical connectors to implement inter-board optical interconnection. In this case, correspondingly, the first cable assembly 500 may use an optical fiber assembly.

In a possible embodiment, the first cable assembly 500 may include a first cable 501 and a first board-end connector 502. The first board-end connector 502 may be directly installed on the first circuit board 100, to implement an electrical connection to the first circuit board 100. A first end of the first cable 501 may be electrically connected to the first board-end connector 502, and a second end of the first cable 501 may be electrically connected to the first connector 300, so that the first connector 300 is electrically connected to the first board-end connector 502. In this way, the first connector 300 may be electrically connected to the first circuit board 100. During specific application, the first cable 501 may lead a signal from the first connector 300 to the first board-end connector 502, then to the first circuit board 100, and last to the first chip 101 through a transmission line on the first circuit board 100, to complete a transmission process of the signal from the first connector 300 to the first chip 101 on the first circuit board 100. It should be noted that a disposing position of the first board-end connector 502 on the first circuit board 100 shown in FIG. 3 and FIG. 4 is merely an example. During actual disposing, the first board-end connector 502 may be selectively connected to a position that is on the first circuit board 100 and that is close to the first chip 101, to shorten the transmission line on the first circuit board 100 and reduce the system power consumption.

During specific implementation, the first board-end connector 502 may be specifically installed on the first circuit board 100 in a crimping manner, or may be directly installed by using a screw in a spring manner, so that a pin of the first board-end connector 502 is directly connected to a pin of the first circuit board 100, to further implement the electrical connection between the first board-end connector 502 and the first circuit board 100.

The first cable assembly 500 may be electrically connected to the first connector 300 in a welding manner, and the second end of the first cable 501 may be specifically welded to a pin of the first connector 300. One first cable assembly 500 may include a plurality of first cables 501. In other words, one first board-end connector 502 may be electrically connected to one first connector 300 via the plurality of first cables 501. This may be specifically determined based on a signal transmission requirement during actual application.

As shown in FIG. 4, in a possible embodiment, an installation board 700 may be disposed between the first circuit board 100 and the second circuit board 200, and the first connector 300 may be fastened to the installation board 700. During specific disposing, a window may be disposed on the installation board 700, and the first connector 300 may be clamped in the window. Two ends of the first connector 300 may be respectively located on two sides of the installation board 700, so that the first connector 300 is fastened on the installation board 700.

The installation board 700 is mainly used to carry the first connector 300, and provides an installation slot for the first connector 300 by disposing the window. There may be a plurality of windows, so that installing of a plurality of first connectors 300 can be met. Therefore, the installation board 700 may be considered as an integrated board of the plurality of first connectors 300. The installation board 700 may be a common board-type mechanical part, or may be a circuit board.

During specific implementation, the first circuit board 100 and the second circuit board 200 are respectively disposed on two sides of the installation board 700 and are disposed vertically to each other. The installation board 700 may be disposed vertically to the first circuit board 100 and the second circuit board 200 separately, to implement a connection between the first connector 300 and the second connector 400 on the second circuit board 200, and a connection between the first connector 300 and the first board-end connector 502 on the first circuit board 100.

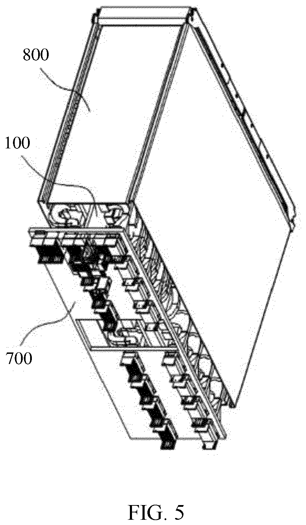

FIG. 5 is a schematic diagram of a partial structure of an orthogonal system architecture according to an embodiment of this application. The second circuit board and the second connector are hidden in the figure. As shown in FIG. 5, in a possible embodiment, the orthogonal system architecture may include a housing 800, and the first circuit board 100 is disposed in the housing 800. When there are a plurality of first circuit boards 100, the plurality of first circuit boards 100 are all located in the housing 800, to protect the plurality of first circuit boards 100 via the housing 800. Based on an actual requirement, the housing 800 may further have a shielding function, to perform electromagnetic shielding on the plurality of first circuit boards 100 disposed in the housing 800.

During specific implementation, for example, the first circuit board 100 may be fastened in the housing 800 via a connecting member such as a bracket or the like. Alternatively, the first circuit board 100 may be clamped and fastened in the housing 800 via a slot-shaped structure. Alternatively, the first circuit board 100 may be fastened in the housing 800 via a slot-shaped structure and a connecting member. Certainly, the first circuit board 100 may alternatively be fastened in the housing 800 in another manner. This may be determined based on an actual application scenario, and is not specifically limited in this application. For example, the housing 800 may be in a cuboid shape, or may be in another shape. This is not specifically limited in this application either.

For a disposing relationship between the installation board 700 and the housing 800, during specific disposition, the installation board 700 may be disposed outside the housing 800, and faces a side wall of the housing 800, in other words, parallel to the side wall of the housing 800. In this case, the installation board 700 and the housing 800 may be connected to each other via an installation member, so that relative positions of the installation board 700 and the housing 800 remain unchanged. Alternatively, the housing 800 may have an opening. The installation board 700 is fastened to the opening, and the installation board 700 is used as a side wall of the housing 800. In this case, the installation board 700 may be detachably connected to the housing 800, or may be integrally formed with the housing 800.

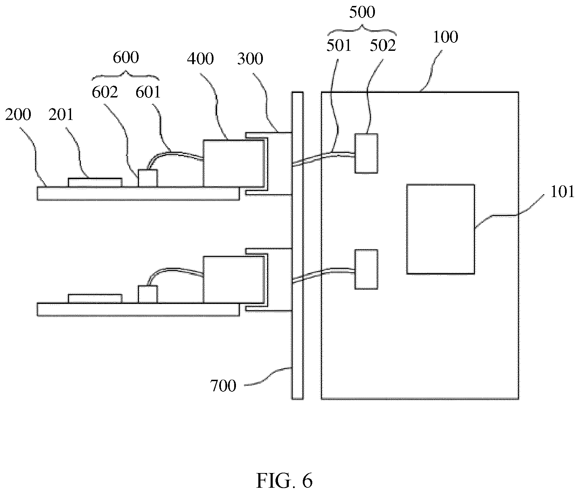

FIG. 6 is a schematic side view of a structure of another orthogonal system architecture according to an embodiment of this application. As shown in FIG. 6, in some other embodiments, an orthogonal system architecture provided in this application may include a first circuit board 100, a second circuit board 200, a first connector 300, and a second connector 400. The first circuit board 100 and the second circuit board 200 may be disposed vertically to each other. The first connector 300 may be electrically connected to the first circuit board 100 via a first cable assembly 500. Different from the foregoing embodiment, the second connector 400 may be electrically connected to the second circuit board 200 via a second cable assembly 600.

During actual application, the first connector 300 is plug-connected to the second connector 400, to implement an electrical connection between the first circuit board 100 and the second circuit board 200.

The second connector 400 may be relatively fastened to the second circuit board 200. For example, the second connector 400 may be fastened to the second circuit board 200 via a connecting member such as a buckle, a screw, or the like, so that relative positions of the first connector 300 and the second connector 400 remain unchanged. The second connector 400 fastened to the second circuit board 200 is electrically connected to the second circuit board 200 via the second cable assembly 600.

In the orthogonal system architecture in this embodiment of this application, the first circuit board 100 is electrically connected to the first connector 300 via the first cable assembly 500, and the second circuit board 200 is electrically connected to the second connector 400 via the second cable assembly 600. Compared with transmitting a signal through a transmission line on a board, a cable has relatively good high-speed performance and a relatively low signal loss. This can improve system high-speed performance. In addition, a signal is transmitted through the cable, so that cross transmission lines in the first circuit board 100 and the second circuit board 200 can be avoided. In this way, restrictions on quantities of layers and board materials of the first circuit board 100 and the second circuit board 200 are all relaxed, and design and manufacturing costs of circuit boards that are inserted vertically to each other are reduced.

During specific implementation, an end that is of the first cable assembly 500 and that is electrically connected to the first circuit board 100 may be disposed close to a first chip 101 on the first circuit board 100, so that an intra-board transmission line on the first circuit board 100 can be greatly shortened, and SI performance of the first circuit board 100 can be improved. In addition, CDR on the first circuit board 100 can be reduced, to further reduce system power consumption. Similar to a disposing manner of the first cable assembly 500, an end that is of the second cable assembly 600 and that is electrically connected to the second circuit board 200 may be disposed close to a second chip 201 on the second circuit board 200, so that an intra-board transmission line of the second circuit board 200 can be greatly shortened, and SI performance of the second circuit board 200 can be improved. In addition, CDR on the second circuit board 200 can be reduced, to further reduce system power consumption.

During actual application, similarly, there may be at least one first circuit board 100 and at least one second circuit board 200. The orthogonal system architecture in this embodiment of this application is applicable to a one-to-one circuit board interconnection, a one-to-many circuit board interconnection, and a many-to-many circuit board interconnection.

In a possible embodiment, because the first cable assembly 500 and the second cable assembly 600 are disposed, the first connector 300 and the second connector 400 that are mutually plug-connected and fitted may use a straight male connector and a curved female connector that are mutually plug-connected and fitted, or may use a straight male connector and a straight female connector that are mutually plug-connected and fitted, so that vertical inter-insertion between the first circuit board 100 and the second circuit board 200 can be implemented. For example, the first connector 300 uses the straight male connector. In this case, the second connector 400 may use the curved female connector or the straight female connector. Alternatively, the first connector 300 uses the curved female connector or a straight female connector. In this case, the second connector 400 may use the straight male connector. FIG. 6 shows a case in which the first connector 300 uses the straight male connector, and the second connector 400 uses the straight female connector.

Compared with an existing orthogonal system architecture that implements vertical inter-insertion between boards by using an orthogonal connector, in the orthogonal system architecture in this embodiment of this application, when the first connector 300 and the second connector 400 use the straight male connector and the curved female connector that are mutually plug-connected and fitted, an insertion loss caused by a design in which a pin of one connector in one group of connectors is rotated by 90° is reduced. When the first connector 300 and the second connector 400 use the straight male connector and the straight female connector that are mutually plug-connected and fitted, an insertion loss caused by a design in which pins of two connectors in one group of connectors are rotated by 90° is reduced.

In a possible embodiment, the first cable assembly 500 may include a first cable 501 and a first board-end connector 502. The first board-end connector 502 may be directly plug-connected to the first circuit board 100, to implement an electrical connection to the first circuit board 100. A first end of the first cable 501 may be electrically connected to the first board-end connector 502, and a second end of the first cable 501 may be electrically connected to the first connector 300, so that the first connector 300 is electrically connected to the board-end connector. In this way, the first connector 300 is electrically connected to the first circuit board 100. Similarly, the second cable assembly 600 may include a second cable 601 and a second board-end connector 602. The second board-end connector 602 may be directly plug-connected to the second circuit board 200, to implement an electrical connection to the second circuit board 200. A second end of the second cable 601 may be electrically connected to the second board-end connector 602, and a second end of the second cable 601 may be electrically connected to the second connector 400, so that the second connector 400 is electrically connected to the board-end connector. In this way, the second connector 400 is electrically connected to the second circuit board 200.

During actual disposing, the first board-end connector 502 may be selectively connected to a position that is on the first circuit board 100 and that is close to the first chip 101, to shorten the transmission line on the first circuit board 100 and reduce the system power consumption. Similarly, the second board-end connector 602 may be selectively connected to a position that is on the second circuit board 200 and that is close to the second chip 201, to shorten the transmission line on the second circuit board 200 and further reduce the system power consumption.

For a manner of installing the first board-end connector 502 and the second board-end connector 602 on corresponding circuit boards, and a manner of implementing an electrical connection between the first cable assembly 500 and a corresponding connector and an electrical connection between the second cable assembly 600 and a corresponding connector, refer to the foregoing embodiment. Details are not described again.

During specific implementation, one first cable assembly 500 may include a plurality of first cables 501. In other words, one first board-end connector 502 may be electrically connected to one first connector 300 via the plurality of first cables 501. Similarly, one second cable assembly 600 may include a plurality of second cables 601. In other words, one second board-end connector 602 may be electrically connected to one second connector 400 via the plurality of second cables 601.

In a possible embodiment, an installation board 700 may be disposed between the first circuit board 100 and the second circuit board 200, and the first connector 300 may be fastened to the installation board 700. The first circuit board 100 is disposed in a housing. When there are a plurality of first circuit boards 100, the plurality of first circuit boards 100 are all located in the housing. The installation board 700 may be disposed outside the housing and faces a side wall of the housing, in other words, parallel to the side wall of the housing. Alternatively, the housing may have an opening. The installation board 700 is fastened to the opening, and the installation board 700 is used as a side wall of the housing.

An embodiment of this application provides a method for manufacturing an orthogonal system architecture. In a possible embodiment, the method may include the following steps:

Electrically connect one end of a first cable assembly to a first circuit board. During specific implementation, the first cable assembly may include a first cable and a first board-end connector. The first board-end connector is disposed on the first circuit board and is electrically connected to the first circuit board, and one end of the first cable is electrically connected to the first board-end connector, to implement an electrical connection between the first cable and the first circuit board.

Dispose an installation board, to enable the first circuit board to be located on one side of the installation board, and dispose a first connector on the installation board. During specific implementation, a window may be disposed on the installation board, the first connector may be clamped in the window, and two ends of the first connector may be respectively located on two sides of the installation board. Electrically connect the first connector to the other end of the first cable, to implement an electrical connection between the first connector and the first circuit board.

Dispose a second circuit board, to enable the second circuit board to be located on another side of the installation board, and dispose a second connector on the second circuit board. During specific implementation, the second connector may be fastened to the second circuit board via a connecting member such as a buckle, a screw, or the like. Electrically connect the second connector to the second circuit board.

Dispose the second circuit board vertically to the first circuit board, and plug-connect the second connector to the first connector, so that the second circuit board is electrically connected to the first circuit board in a vertically inter-inserted manner, to form a backplane-free orthogonal system architecture.

In a possible embodiment, when being electrically connected to the second circuit board, the second connector may be electrically connected to the second circuit board via a second cable assembly. During specific implementation, the second cable assembly may include a second cable and a second board-end connector. The second board-end connector is disposed on the second circuit board and is electrically connected to the second circuit board, one end of the second cable is electrically connected to the second board-end connector, and the other end of the second cable is electrically connected to the second connector, to implement an electrical connection between the second connector and the second circuit board.

The foregoing descriptions are merely specific implementations of this application, but are not intended to limit the protection scope of this application. Any variation or replacement readily figured out by a person skilled in the art within the technical scope disclosed in this application shall fall within the protection scope of this application.

## Claims

1. An orthogonal system architecture, comprising a first circuit board, a second circuit board, a first connector, and a second connector, wherein
the first circuit board and the second circuit board are disposed vertically to each other; and
the first connector is electrically connected to the first circuit board via a first cable assembly, the second connector is disposed on the second circuit board and is electrically connected to the second circuit board, and the first connector is plug-connected to the second connector, to electrically connect the first circuit board to the second circuit board.

2. The orthogonal system architecture according to claim 1, wherein the first connector is a straight male connector, and the second connector is a curved female connector; or
the first connector is a curved female connector, and the second connector is a straight male connector.

3. The orthogonal system architecture according to claim 1 or 2, wherein the first cable assembly comprises a first cable and a first board-end connector, the first board-end connector is disposed on the first circuit board and is electrically connected to the first circuit board, one end of the first cable is electrically connected to the first board-end connector, and the other end of the first cable is electrically connected to the first connector.

4. The orthogonal system architecture according to claim 1, wherein the second connector is electrically connected to the second circuit board via a second cable assembly.

5. The orthogonal system architecture according to claim 4, wherein the first connector is a straight male connector, and the second connector is a curved female connector or a straight female connector; or
the first connector is a curved female connector or a straight female connector, and the second connector is a straight male connector.

6. The orthogonal system architecture according to claim 4 or 5, wherein the second cable assembly comprises a second cable and a second board-end connector, the second board-end connector is disposed on the second circuit board and is electrically connected to the second circuit board, one end of the second cable is electrically connected to the second board-end connector, and the other end of the second cable is electrically connected to the second connector.

7. The orthogonal system architecture according to any one of claims 1 to 6, further comprising an installation board, wherein the installation board is disposed between the first circuit board and the second circuit board, and the first connector is disposed on the installation board.

8. The orthogonal system architecture according to claim 7, wherein a window is disposed on the installation board, and the first connector is disposed in the window.

9. The orthogonal system architecture according to claim 7 or 8, further comprising a housing, wherein the first circuit board is disposed in the housing; and
the installation board is disposed outside the housing and faces a side wall of the housing.

10. A network device, comprising an interface processing unit and the orthogonal system architecture according to any one of claims 1 to 9, wherein
the interface processing unit is disposed on the first circuit board or the second circuit board.

11. A method for manufacturing an orthogonal system architecture, comprising:
electrically connecting one end of a first cable assembly to a first circuit board;
disposing an installation board, to enable the first circuit board to be located on one side of the installation board, disposing a first connector on the installation board, and electrically connecting the first connector to the other end of the first cable assembly;
disposing a second circuit board, to enable the second circuit board to be located on another side of the installation board, disposing a second connector on the second circuit board, and electrically connecting the second connector to the second circuit board; and
disposing the second circuit board vertically to the first circuit board, and plug-connecting the second connector to the first connector, to electrically connect the second circuit board to the first circuit board.

12. The method for manufacturing an orthogonal system architecture according to claim 11, wherein the second connector is electrically connected to the second circuit board via a second cable assembly.
